(19)

Europäisches
Patentamt
European
Patent Office
Office européen
des brevets

(11) **EP 4 338 836 A1**

(12) **EUROPEAN PATENT APPLICATION**
published in accordance with Art. 153(4) EPC

(43) Date of publication:
**20.03.2024 Bulletin 2024/12**

(21) Application number: **23740476.9**

(22) Date of filing: **12.01.2023**

(51) International Patent Classification (IPC):
*B01J 37/02* $^{(2006.01)}$    *B01J 35/10* $^{(2006.01)}$
*B01J 35/02* $^{(2006.01)}$    *B01J 23/75* $^{(2006.01)}$
*B01J 37/08* $^{(2006.01)}$    *C01B 32/162* $^{(2017.01)}$
*C23C 16/455* $^{(2006.01)}$

(52) Cooperative Patent Classification (CPC):
**B01J 23/75; B01J 35/00; B01J 35/30; B01J 35/60;
B01J 37/02; B01J 37/08; C01B 32/162;
C23C 16/455**

(86) International application number:
**PCT/KR2023/000588**

(87) International publication number:
**WO 2023/136633 (20.07.2023 Gazette 2023/29)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **13.01.2022  KR 20220005135
13.01.2022  KR 20220005137**

(71) Applicant: **LG Chem, Ltd.
Yeongdeungpo-gu
Seoul 07336 (KR)**

(72) Inventors:
• **KIM, Eui Tae
Daejeon 34122 (KR)**

• **LEE, Eun Jeong
Daejeon 34122 (KR)**
• **KIM, Ki Hwan
Daejeon 34122 (KR)**
• **OH, Eu Gene
Daejeon 34122 (KR)**
• **PARK, Sung Eun
Daejeon 34122 (KR)**
• **LEE, Geun Sung
Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **CATALYST FOR MANUFACTURING CARBON NANOTUBES**

(57)    The present invention relates to a catalyst for producing carbon nanotubes, a method for preparing the catalyst, and a method for producing carbon nanotubes using the catalyst which includes a support, and an active layer formed on a surface of the support, wherein the active layer contains CoO and $Co_3O_4$, and has, through XRD pattern measurement, one peak at $2\theta= 35°$ to $38°$, and one peak at $2\theta= 41°$ to $44°$, and a proportion of CoO among the CoO and $Co_3O_4$ is 55 at% or more. The catalyst according to the present invention can efficiently synthesize low-diameter carbon nanotubes.

FIG. 1

EP 4 338 836 A1

**Description**

**TECHNICAL FIELD**

**Cross-reference to Related Applications**

This application claims priority from Korean Patent Application Nos. 10-2022-0005135, filed on January 13, 2022, and 10-2022-0005137, filed on January 13, 2022, the disclosures of which are incorporated by reference herein.

**Technical Field**

The present invention relates to a catalyst for producing carbon nanotubes and a method for preparing the same, with which it is possible to obtain, with high yield, uniform carbon nanotubes having a small diameter even using a small amount of a catalyst, since the catalyst has a thin and uniform active layer and a high CoO proportion in the active layer.

**BACKGROUND ART**

Carbon nanotube materials include fullerenes, carbon nanotubes (CNTs), graphenes, and graphite nanoplates, and the like, according to the shape of the material, and among them, the carbon nanotubes are macromolecules in which a hexagonal honeycomb-shaped graphite sheet, in which one carbon atom is bonded to other three carbon atoms, is rolled up to have a diameter of nanometer scales.
The carbon nanotubes are hollow and light, and have electrical conductivity as good as copper, thermal conductivity as excellent as diamond, and tensile force equivalent to that of steel. According to the rolled-up shape, the carbon nanotubes may be classified into single-walled carbon nanotubes (SWCNTs), multi-walled carbon nanotubes (MWCNTs), and rope carbon nanotubes.
Recently, research on carbon nanotube synthesis technology capable of synthesizing a large amount of carbon nanotubes at one time is being actively conducted, and among various methods, chemical vapor deposition (CVD) using a fluidized bed reactor can easily synthesize a large amount of carbon nanotubes, and thus, is most preferred in actual industrial fields.
Specifically, in the chemical vapor deposition, a particle-shaped catalyst for producing carbon nanotubes is filled in a fluidized bed reactor, and then is made to float while injecting a carbon source gas and a flow gas into the fluidized bed reactor. Thereafter, the reactor is heated to decompose the carbon source gas on the surface of the floating catalyst, thereby synthesizing carbon nanotubes.
In the production process for carbon nanotubes using the chemical vapor deposition, the activity of the catalyst acts as a main factor that can determine the productivity of the overall production process, and accordingly, studies are actively conducted on a catalyst having higher activity and a production method thereof. Conventionally, the most commonly used method for preparing a catalyst is an impregnation method, in which a support is immersed in a solution in which an active ingredient precursor is dissolved, the active ingredient precursor is placed on the inside and surface of the support, and then drying and firing are performed to prepare catalyst particles. The impregnation method is advantageous in terms of a simple process and easy mass production of catalysts, but is disadvantageous in that there is a limitation in uniform distribution of the active ingredient on the support, and the non-uniformity of the active ingredient results in deterioration of the uniformity of the physical properties of the finally produced carbon nanotubes. In particular, recently, since there are increasing demands for high-quality carbon nanotubes to be used as conductive materials, it is required to conduct researches on a novel catalyst capable of synthesizing higher-quality carbon nanotubes and a method for preparing the same.

**Prior Art Document**

(Patent Document 1) KR 10-2020-0141772 A
(Patent Document 2) KR 10-2018-0101222 A

**DETAILED DESCRIPTION OF THE INVENTION**

**TECHNICAL PROBLEM**

An object of the present invention is to provide a catalyst for producing carbon nanotubes and a method for preparing the same, with which uniform carbon nanotubes having a small diameter can be produced with high efficiency and high yield.

In addition, another object of the present invention is to provide a method for producing carbon nanotubes using the catalyst.

**TECHNICAL SOLUTION**

According to an aspect of the present invention, there is provided a catalyst for producing carbon nanotubes, a method for preparing the catalyst, and a method for producing carbon nanotubes using the catalyst.

Specifically, (1) the present invention provides a catalyst for producing carbon nanotubes, the catalyst comprising: a support and an active layer formed on a surface of the support, wherein the active layer contains CoO and $Co_3O_4$, and has, through XRD pattern measurement, one peak at $2\Theta=35°$ to $38°$, and one peak at $2\Theta=41°$ to $44°$, and a proportion of CoO among the CoO and $Co_3O_4$ is 55 at% or more.

(2) The present invention provides the catalyst for producing carbon nanotubes according to (1), wherein the support is a metal oxide support having a hydroxyl group on a surface thereof.

(3) The present invention provides the catalyst for producing carbon nanotubes according to (1) or (2), wherein the support has a specific surface area of 1 $m^2/g$ to 300 $m^2/g$.

(4) The present invention provides the catalyst for producing carbon nanotubes according to any one of (1) to (3), wherein the support has a number-average particle size of the support is 0.5 um to 100 $\mu$m.

(5) The present invention provides the catalyst for producing carbon nanotubes according to any one of (1) to (4), wherein the support is at least one selected from the group consisting of aluminum oxide, hydrotalcite, and boehmite.

(6) The present invention provides the catalyst for producing carbon nanotubes according to any one of (1) to (5), wherein the catalyst has an active layer content of 1 wt% to 10 wt%.

(7) The present invention provides the catalyst for producing carbon nanotubes according to any one of (1) to (6), wherein the catalyst has an active layer thickness of 0.5 nm to 5 nm.

(8) The present invention provides a method for preparing a catalyst for producing carbon nanotubes, the method comprising a step of loading a support into a reactor (S1), and a step of forming a catalyst layer on a surface of the support using atomic layer deposition (S2), wherein, the step (S2) is performed by sequentially repeating the following steps 5 to 300 times: a step of injecting a catalyst precursor gas into the reactor (S2-1); a step of primary purging the inside of the reactor with an inert gas (S2-2); a step of injecting a reaction gas into the reactor (S2-3); and a step of secondarily purging the inside of the reactor with an inert gas (S2-4).

(9) The present invention provides the method for preparing a catalyst for producing carbon nanotubes according to (1), further comprising a step (S0) of pre-treating the support before or after the step (S1).

(10) The present invention provides the method for preparing a catalyst for producing carbon nanotubes according to (8) or (9), wherein the reaction gas contains nitrogen or oxygen.

(11) The present invention provides the method for preparing a catalyst for producing carbon nanotubes according to any one of (8) to (10), wherein the step S2 is performed under a pressure condition of 0.1 Torr to 10 Torr.

(12) The present invention provides the method for preparing a catalyst for producing carbon nanotubes according to any one of (8) to (11), wherein the step S1 further comprises heating the inside of the reactor to 100 °C to 400 °C.

(13) The present invention provides a method for producing carbon nanotubes, the method comprising: a step of filling the inside of a reactor (S1) with the catalyst of according to any one of (1) to (7); a step of injecting a carbon source gas into the reactor (S2); and a step of heating the reactor (S3).

**ADVANTAGEOUS EFFECTS**

When a catalyst for producing carbon nanotubes according to the present invention is used, the active layer of the catalyst is thin. Therefore, carbon nanotubes thus produced may also become smaller, and the active layer is uniformly distributed, and thus uniform carbon nanotubes can be produced. In addition, since the catalyst for producing carbon nanotubes according to the present invention has excellent catalytic activity, a large amount of carbon nanotubes may be synthesized even with a small amount of the catalyst.

**BRIEF DESCRIPTION OF DRAWING**

FIG. 1 shows an XRD pattern graph of a catalyst according to Example 1 of the present invention.
FIG. 2 shows an XRD pattern graph of a catalyst according to Example 2 of the present invention.
FIG. 3 shows an XRD pattern graph of a catalyst according to Comparative Example of the present invention.
FIG. 4 shows an SEM image of carbon nanotubes produced using the catalyst according to Example 1 of the present invention.
FIG. 5 shows an SEM image of carbon nanotubes produced using the catalyst according to Comparative Example of the present invention.

**MODE FOR CARRYING OUT THE INVENTION**

Hereinafter, the present invention will be explained in more detail.

It will be understood that words or terms used in the specification and claims shall not be interpreted as the typical or lexical meaning, and it will be further understood that the words or terms should be interpreted as having a meaning that is consistent with their meaning in the context of the relevant art and the technical idea of the invention, based on the principle that an inventor may properly define the meaning of the words or terms to best explain the invention.

**Catalyst For Producing Carbon Nanotubes**

A catalyst used in a carbon nanotube production process using a chemical vapor deposition is generally prepared using an impregnation method. Producing a catalyst using the impregnation method provides advantages of being simple and economical, but in many cases, an active ingredient is not uniformly supported on the surface of a support particle during a support process. Accordingly, even when synthesizing carbon nanotubes using the catalyst thus produced, there is a problem in that the carbon nanotubes do not grow uniformly. Therefore, there are increasing demands for a catalyst capable of synthesizing carbon nanotubes more uniformly and a producing method thereof, and accordingly, the present invention provides a novel catalyst for producing carbon nanotubes capable of uniformly synthesizing high-quality carbon nanotubes.

Specifically, the present invention provides a catalyst for producing carbon nanotubes, the catalyst including: a support; and an active layer formed on a surface of the support, wherein the active layer contains CoO and $Co_3O_4$, and shows, through XRD pattern measurement, one peak at $2\Theta=35°$ to $38°$, and one peak at $2\Theta=41°$ to $44°$, and a proportion of CoO among the CoO and $Co_3O_4$ is 55 at% or more.

The catalyst provided by the present invention is prepared using an atomic layer deposition (ALD) rather than a conventional impregnation method, and the catalyst according to the present invention may be prepared by forming an active layer thinly and uniformly on the surface of a support through an atomic layer deposition.

Hereinafter, the catalyst for producing carbon nanotubes according to the present invention will be described in more detail.

**Support**

The catalyst for producing carbon nanotubes according to the present invention is prepared using an atomic layer deposition. Since the atomic layer deposition is a method that can uniformly form an active layer even on a high-specific-surface-area support having a 3D structure, the catalyst for producing carbon nanotubes according to the present invention includes a support having a high specific surface area.

Specifically, the support included in the catalyst for producing carbon nanotubes according to the present invention may be a metal oxide support having a hydroxyl group on the surface thereof. When a hydroxyl group is present on the surface of the support, it is advantageous in an atomic layer deposition. In addition, the specific surface area of the support may be 1 to 300 $m^2/g$, preferably 10 to 200 $m^2/g$, and the number-average particle size of the support may be 0.5 to 100 um, preferably 1 to 20 $\mu$m. When the physical properties of the support satisfy the above conditions, it is possible to coat a large amount of the catalytic component while satisfactorily maintaining the mechanical strength of the support itself.

In addition, the bulk density of the support may be 0.05 to 1 g/cc, preferably 0.1 g/cc to 0.5 g/cc. When the bulk density of the support is within the above-described range, the support has an advantage in that a large amount of the active component may be coated relative to the volume of the support, thereby increasing the activity of the catalyst.

More specifically, the support may be at least one selected from the group consisting of aluminum oxide ($Al_2O_3$), hydrotalcite, and boehmite, and particularly the support may be preferably hydrotalcite. The supports of the above-described type are advantageous in that the supports strongly interact with the catalyst to maintain the dispersion of catalyst particles during the growth of carbon nanotubes, thereby making it possible to produce carbon nanotubes with a uniform diameter. Therefore, the supports are particularly suitable for use as supports in the catalyst preparation method according to the present invention. Meanwhile, in conventional methods for preparing a catalyst using an atomic layer deposition, zirconia or a carbon-based support was used as a support. In the case of using the above-described support compared to the conventional supports, a large amount of catalyst may be supported due to the high specific surface area of the support itself, so that carbon nanotubes can be produced at high yield. In addition, particularly, hydrotalcite may provide technical advantages in that since there are differences in interaction with catalyst particles in each of aluminum and the magnesium regions due to the nanostructure of the aluminum and the magnesium regions divided in units of atom on the surface, the size of the catalyst particles may be controlled to be more smaller, thereby making it possible to produce thin and uniform carbon nanotubes.

## Active Layer

The catalyst for producing carbon nanotubes according to the present invention includes an active layer formed on the surface of the above-described support, and the active layer includes a Co oxide.

Cobalt is a component commonly used as an active component of a catalyst for producing carbon nanotubes, and has advantages of high catalytic activity and excellent stability. Accordingly, in the present invention, cobalt is employed as an active component, and cobalt is converted into an oxide form during the catalyst preparation process and is located as an active layer on the surface of the support. Accordingly, the active layer according to the present invention includes a Co oxide.

Also, the composition of the Co oxide may vary depending on variables during the preparation process, for example, depending on which method is used as a catalyst preparation method, and the temperature range for heat treatment/calcination. The Co oxide included in the catalytic active layer according to the present invention may include $CoO$ and $Co_3O_4$ among Co oxides having various compositions. Both $CoO$ and $Co_3O_4$ may exhibit high catalytic activity for the synthesis reaction of carbon nanotubes, but $CoO$ has an advantage of being more stable at high temperatures and having excellent active components. Accordingly, a catalyst in which a relative proportion of $CoO$ is high may be evaluated as an excellent catalyst. In this view point, the catalyst provided by the present invention has a relatively high proportion of $CoO$ and a relatively low proportion of $Co_3O_4$ in the composition of the Co oxide in the active layer. More specifically, the proportion of $CoO$ among $CoO$ and $Co_3O_4$ in the catalytic active layer according to the present invention may be 55 at% or more, preferably 85 at% or more. Also, the at% means a percentage based on the number of atoms. When the proportion of $CoO$ is high as described above, the thermal stability is excellent, phenomena such as catalyst collapse in the carbon nanotube production process are reduced due to excellent thermal stability, and the catalyst has high catalytic activity, thereby making it possible to synthesize carbon nanotubes with high efficiency.

The presence of $CoO$ in the composition of the Co oxide may be confirmed, through XRD pattern measurement for the catalyst, from two peaks at $2\Theta=35°$ to $45°$, more specifically, one peak at $2\Theta=35°$ to $38°$, and one peak at $2\Theta=41°$ to $44°$.

XRD pattern analysis is a means capable of confirming whether various metal components present in the catalyst are present or not, and it has been known that two peaks are shown in the above-described $2\theta$ range when $CoO$ is present. Therefore, the carbon nanotube catalyst provided herein shows, through XRD pattern measurement, one peak at $2\Theta=35°$ to $38°$ and one peak at $2\Theta=41°$ to $44°$.

In addition to the two peaks in the above range, one peak at $2\theta=30°$ to $31°$ and one peak at $2\theta=44°$ to $45°$ may further appear in the XRD pattern measurement for the catalyst according to the present invention, depending whether $Co_3O_4$ is present or not. The above-described ratio between $CoO$ and $Co_3O_4$ may also be expressed as the intensity ratio of the peaks. In the catalyst for preparing carbon nanotubes according to the present invention, the intensity of the $CoO$ peak/the intensity of the $Co_3O_4$ peak may be 0.55 to 1. When the intensity ratio is within the above range, the relative proportion of $CoO$ is sufficiently high, and both thermal stability and catalytic activity may be excellent.

Also, based on the total weight of the catalyst, the content of the active layer may be 1 wt% to 10 wt%, preferably 1 wt% to 2 wt%. This content is lower than that of a conventional catalyst prepared using the impregnation method, which means that the catalyst for producing carbon nanotubes according to the present invention may exhibit sufficiently excellent catalytic activity even with a low content of the active layer. When the content of the active layer is less than the above-described range, the absolute content of the active layer component is insufficient to result in a decrease in catalytic activity; when the content of the active layer is excessively large, there are economical disadvantages in that the cost of the catalyst preparing process increases, but the catalyst activity is improved little, or even lowered.

As described above, the active layer of the catalyst for producing carbon nanotubes provided herein is formed through the atomic layer deposition. Due to the characteristics of the atomic layer deposition, an active layer having a certain thickness is formed during one cycle, and the thickness of the active layer may be appropriately controlled by adjusting the number of cycles within an appropriate range. In particular, in the present invention, the thickness of the active layer may be preferably 0.5 nm to 5 nm, and particularly preferably 0.5 nm to 2 nm. This is because, when the thickness of the active layer is within the above range, it is advantageous to produce small-diameter carbon nanotubes by maintaining the overall catalyst particle diameter to be small.

**Method for Preparing Catalyst for Producing Carbon Nanotubes**

The present invention provides a method for preparing the above-described catalyst for producing carbon nanotubes. Specifically, the present invention provides a method for preparing a catalyst for producing carbon nanotubes, the method including a step of loading a support into a reactor (S1), and a step of forming a catalyst layer on a surface of the support using atomic layer deposition (S2), wherein, the step (S2) is performed by sequentially repeating the following steps 5 to 300 times: a step of injecting a catalyst precursor gas into the reactor (S2-1) ; a step of primary purging the inside of the reactor with an inert gas (S2-2); a step of injecting a reaction gas into the reactor (S2-3) ; and a step of secondarily purging the inside of the reactor with an inert gas (S2-4).

Hereinafter, the method for preparing a catalyst for producing carbon nanotubes according to the present invention will be described in more detail step by step.

**Loading Step (S1)**

In order to form the catalyst layer on the surface of the support, a step of loading the support into the reactor is performed first. In order to form a uniform coating layer on the surface of the support particle, it is necessary to maximize the contact area between the catalyst precursor gas to be introduced later and the support, and to this end, the support may be loaded in various forms into reactors of various types.

Specifically, when a deposition apparatus for a flat substrate is used as the reactor, the loading may be performed by applying support particles thinly and evenly on the substrate so as to maximize the contact area between the support particles and the catalyst precursor gas, and the application may be performed using equipment such as a blade coater, a roll press, or a dip coater. Also, the physical structure of the support particles should not be collapsed or the support particles should not be decomposed during the application process, and therefore the application should be performed under appropriate conditions.

Meanwhile, when a deposition apparatus for particle-only is used as the reactor, the loading may be performed by mixing the support particles themselves with the catalyst precursor gas in a reactor chamber to maximize the contact area between the support particles and the catalyst precursor gas. In this case, the mixing method may be a rotary method, in which the reactor itself rotates, or a fluidized method, in which gas is injected into the reactor from below the reactor to make the support particles float and be mixed with the gas. In addition, in this process, a stirring apparatus such as an impeller may be added and used in the reactor to further increase mixing efficiency. The deposition apparatus for a substrate is disadvantageous in that when the amount of support particles to be processed is large, there is a limitation to thinly and evenly applying the support particles on the substrate; however, the deposition apparatus for particle-only is advantageous in processing a relatively large amount of support particles because of having no limitation as above. In addition, in order to continuously process a large amount of support particles, a plurality of mixing-type reactors may be used or a conveyor belt-type method for conveying the particles may be adopted.

Also, before or after the loading step (S1), a step of pre-treating the support (S0) may be additionally performed. When the moisture content in the support is relatively high, it is likely that the reaction of the catalyst precursor gas injected in a later step may not be performed favorably or undesired side reactions may occur. Therefore, it is necessary to minimize the moisture content in the support as much as possible, and to this end, the pre-treatment may be performed. When the pre-treatment is performed before the loading step, the support particles may be pre-treated first and then loaded into the reactor; and when the pre-treatment is performed after the loading step, the support may be loaded into the reactor and then the pre-treatment may be performed in a state in which the support is loaded.

When the pre-treatment is performed before the loading step, the pre-treatment may be performed by drying the support in a vacuum state, and the moisture content in the support after the pre-treatment may be 100 ppm or less, preferably 10 ppm or less. When the moisture content in the support is low as described above, the subsequent formation of the coating layer may be performed more favorably. Also, the specific temperature and time conditions for the pre-treatment may vary depending on the type or amount of the support to be pre-treated, but the pre-treatment temperature may be 300 °C or less, preferably 150 °C or less to prevent thermal decomposition of the support. In addition, vacuum during this pre-treatment may mean that the pressure is 0.01 Torr or less.

When the pre-treatment is performed in the reactor after the loading step, the pre-treatment may be performed in the above-described vacuum state or in an inert gas atmosphere. When the pre-treatment is performed in an inert gas atmosphere, the flow rate of the inert gas introduced into the reactor and the pre-treatment time may vary depending on the amount, surface area, and moisture content of the support, and the above conditions may be adjusted so that the moisture content in the support after the pre-treating step becomes 100 ppm or less, preferably 10 ppm or less.

Also, the support may be the same as described above.

Also, this loading step may further include, after loading the support into the reactor through the previous step, a step of raising the internal temperature of the reactor to 100 °C to 400 °C. After the support is loaded into the reactor, moisture remaining in the support may be further removed by raising the internal temperature of the reactor to be within the above-described temperature range. In this view point, the heating may be performed under reduced pressure conditions of 10 Torr or less, preferably 1 Torr or less or 0.1 Torr or less.

**Step of Forming Catalyst Layer (S2)**

After loading the support into the reactor through the previous steps, a catalyst layer may be formed on the surface of the support through atomic layer deposition in the reactor, and this catalyst layer formation step may be performed by sequentially repeating the following steps 5 to 300 times: a step of injecting a catalyst precursor gas into the reactor (S2-1); a step of primary purging the inside of the reactor with an inert gas (S2-2); a step of injecting a reaction gas into the reactor (S2-3); and a step of secondarily purging the inside of the reactor with an inert gas (S2-4).

Each time a cycle of the steps S2-1 to S2-4 is performed, a catalyst layer having a certain thickness may be formed, and a catalyst layer having the optimal thickness may be achieved by repeating the cycle 5 to 300 times, preferably 5 to 100 times. In this case, the catalyst layer may have a thickness of 0.1 nm to 10 nm, preferably 0.5 nm to 5 nm, and particularly preferably 0.5 nm to 2 nm. This thickness is smaller than that of a catalyst prepared by conventional impregnation methods, and in the present invention, a thin catalyst layer is used, thereby making it possible to efficiently produce low-diameter carbon nanotubes.

Among the steps S2-1 to S2-4, the step S2-1 is a step of feeding components of a coating layer to be formed on the surface of the support into the reactor, and a catalyst precursor is introduced. Specifically, the catalyst precursor may include a Co precursor and a precursor containing at least one selected from the group consisting of Fe, Ni, V, and Mo. More specifically, the Co precursor may be bis(N-tert-butyl-N'-ethylpropionamidinato) cobalt(II) (CoAMD), cobaltocene, and/or bis(1,4-diisopropyl-1,4-diazabutadiene)cobalt. When the catalyst precursor further includes an Fe precursor, the Fe precursor may be tert-butyl-ferrocene. When the catalyst precursor further includes a Ni precursor, the Ni precursor may be nickel amidinate (Ni-amidinate). When the catalyst precursor further includes a V precursor, the V precursor may be tetrakis(dimethylamido) vanadium and/or tetrakis(ethylmethylamido) vanadium. When the catalyst precursor further includes a Mo precursor, the Mo precursor may be molybdenum hexacarbonyl. In the case of using the above-listed types of catalyst precursors, it is advantageous in that the catalyst precursors are easily vaporized and easily introduced into the reactor in gaseous form, thereby facilitating formation of a catalyst layer. Furthermore, when the catalyst precursor includes a Co precursor together with a precursor containing at least one selected from the group consisting of Fe, Ni, V, and Mo, the catalytic activity can be further improved due to the synergistic effect between Co and other metal components. It is preferable that the catalyst precursor be vaporized and introduced in a gaseous form. A catalyst precursor, which is not easily vaporized, may be introduced together with an inert gas as a carrier gas. In this case, in the present invention, the combination of the catalyst precursor and the carrier gas is referred to as a catalyst precursor gas.

The catalyst precursor injected in this step is adsorbed onto the surface of the support loaded in the reactor, and the adsorbed precursor may be converted into a catalyst layer through a later step.

The injection rate and time of the catalyst precursor gas in this step may vary depending on the properties of the desired catalyst, but the catalyst precursor gas may be injected, for example, at 50 to 200 sccm for 10 seconds or less.

After the step S2-1, a primary purging step (S2-2) is performed. The purpose of the primary purging step and the secondary purging step (S2-4) to be described later is to remove residual components not adsorbed onto the surface of the support, and to achieve the above purpose, the primary purging and the secondary purging are performed using an inert gas. As the inert gas, commonly available nitrogen, argon, or helium gas may be used. The injection rate and time of inert gas in the primary purging and secondary purging steps may be appropriately adjusted as needed, and the inert gas may be injected, for example, at 50 to 500 sccm for 10 to 300 seconds.

After the primary purging step, a reaction gas injection step (S2-3) is performed. The reaction gas introduced in this step may include nitrogen or oxygen. Specifically, when the reaction gas includes nitrogen, at least one among $NH_3$, $N_2H_4$, $C_2H_8N_2$, and $C_4H_{12}N_4$ may be used as the reaction gas. Also, when the reaction gas includes oxygen, at least one among $H_2O$, $O_2$, oxygen plasma, and $O_3$ may be used as the reaction gas. The reaction gas serves to form a thin film on the surface of the support while converting the catalyst precursor to a metal nitride or oxide. When using the above-listed reaction gases, a thin film can be uniformly formed. The reaction gas should be injected to the extent that the previously introduced catalyst precursor may sufficiently react, and reaction gas may be injected, for example, for 10 to 300 seconds at a flow rate of 50 to 500 sccm.

Step S2 including the above-described steps S2-1 to S2-4 may be performed under a pressure condition of 0.1 Torr to 10 Torr, preferably 0.1 Torr to 1 Torr. When atomic layer deposition is performed under low pressure as above-described, there may be advantages that the thickness of the deposited film can be easily controlled and the film can be formed uniformly; when the pressure is lower than the pressure range above, there may be a disadvantage that the deposition rate is too slow; and when the pressure is higher than the pressure range above, there may be disadvantages that it is difficult to control the thickness of the film and difficult to form a uniform film.

**Method for Producing Carbon Nanotubes**

The present invention provides a method for producing carbon nanotubes using the above-described catalyst for producing carbon nanotubes. Specifically, the present invention provides a method for producing carbon nanotubes, the method including a step of filling the inside of a reactor (S1) with the catalyst, a step of injecting a carbon source gas into the reactor (S2), and a step of heating the reactor (S3) .

The catalyst according to the present invention is particularly suitable for use in a carbon nanotube producing process through chemical vapor deposition, and thus, carbon nanotubes can be produced through the above-described process.

The reactor used in the present invention is not particularly limited as long as a reactor is suitable for producing carbon nanotubes using a chemical vapor deposition, and a cylindrical fluidized bed reactor commonly used in the carbon nanotube industry may be used as the reactor. The cylindrical fluidized bed reactor is advantageous in that it is easy to uniformly maintain the internal temperature of the reactor.

The amount of catalyst introduced in step S1 is not particularly limited, and a person skilled in the art may determine an appropriate input amount of catalyst in consideration of the volume or shape of the reactor. The catalyst should be input in an amount enough to allow the carbon nanotube synthesis reaction to proceed sufficiently and to ensure that the internal temperature of the reactor may be sufficiently secured. Meanwhile, the excessive input amount of the catalyst may result in a decrease in productivity of the overall carbon nanotube producing process.

The carbon source gas injected in step S2 is decomposed on the surface of the previously introduced catalyst to form carbon nanotubes. As specific examples of the carbon source gas, various carbon-containing compounds such as aliphatic alkane, aliphatic alkene, aliphatic alkyne, aromatic compounds, etc., may be used, and more particularly, methane, ethane, ethylene, acetylene, ethanol, methanol, acetone, carbon monoxide, propane, butane, benzene, cyclohexane, propylene, butene, isobutene, toluene, xylene, cumene, ethylbenzene, naphthalene, phenanthrene, anthracene, acetylene, formaldehyde, acetaldehyde, etc., may be used.

In addition to the carbon source gas, a flow gas may be injected together with the carbon source gas for the purpose of improving the fluidity of the catalyst inside the reactor. For example, nitrogen gas or inert gas may be used as the flow gas.

The carbon source gas introduced in the previous step S2 is then decomposed on the surface of the catalyst particle through heating in step S3 to form carbon nanotubes. Carbon nanotubes are produced by growing from catalyst particles, and thus, the structural properties of the carbon nanotubes may be determined depending on the diameter or size of the catalyst particles. Also, in this step, heating may be performed such that the internal temperature of the reactor may be 600 °C to 800 °C, preferably 650 °C to 750 °C. When the internal temperature of the reactor is within the above-described range, carbon nanotubes can be favorably synthesized while minimizing thermal decomposition of the catalyst particles.

Carbon nanotubes produced using the catalyst for producing carbon nanotubes according to the present invention may be single-walled carbon nanotubes (SWCNTs) or few-walled carbon nanotubes (FWCNTs). Since the size of the catalyst according to the present invention is relatively small, the size of carbon nanotubes prepared using the catalyst may also be relatively small. In addition, the carbon nanotubes produced through the catalyst for producing carbon nanotubes according to the present invention may be bundle-type carbon nanotubes. Since the active layer is uniformly formed on the surface of the catalyst according to the present invention, carbon nanotube strands growing therefrom grow in the same orientation. Accordingly, the carbon nanotubes produced from the catalyst according to the present invention may be bundle-type carbon nanotubes in which several strands of carbon nanotubes are aligned in one direction to form a bundle.

Hereinafter, the present invention will be described in more detail with reference to Examples and Experimental Examples in order to specifically describe the present invention, but is not limited to Examples and Experimental Examples. The Examples according to the present invention may be modified in various different forms, and the scope of the present invention should not be interpreted to be limited to the Examples described below. Rather, the Examples of the present invention are provided so that this description will be thorough and complete, and will fully convey the scope of the present invention to those skilled in the art.

**Materials**

A pre-treatment was performed such that hydrotalcite having a specific surface area of 20 $m^2/g$ and a number-average particle size of 36 $\mu$m was dried in a vacuum chamber heated at 120 °C for 10 hours to make the moisture content become 10 ppm or less. As a catalyst precursor for forming an active layer, bis(N-tert-butyl-N'-ethylpropionamidinato) cobalt(II) (CoAMD) was used.

## Example 1

The pretreated hydrotalcite was applied thinly and evenly on a glass substrate using a blade coater. Thereafter, the substrate was loaded into a reactor, the pressure was reduced to 0.1 Torr or less, and then the substrate was heated to 200 °C. After the heating was completed, CoAMD heated to 90 °C was injected into the reactor for 30 seconds using a carrier gas, and 100 sccm of nitrogen gas was used as the carrier gas. After the injection of CoAMD was completed, 100 sccm of nitrogen gas was flowed for 30 seconds to complete the primary purging. Thereafter, water vapor ($H_2O$) was injected for 0.4 seconds as a reaction gas with CoAMD, and in this process, 100 sccm of nitrogen gas was used as a carrier gas. After the previous injection of water vapor was completed, 100 sccm of nitrogen gas was flowed again for 90 seconds to complete the secondary purging. The above processes were set as one cycle and the cycle was repeated 10 times in total. As a result, catalyst particles in which a cobalt oxide catalyst layer having a thickness of 0.9 nm was formed on the hydrotalcite were obtained.

## Example 2

In Example 1, the above cycle was repeated 30 times to obtain catalyst particles in which a cobalt oxide catalyst layer having a thickness of 2.7 nm was formed.

## Comparative Example

An immersion liquid was prepared by dissolving 5 g of $Co(NO_3)\cdot 2H_2O$ in 100 ml of water, and then a hydrotalcite support same as that used in Example 1 was immersed in the immersion liquid. Thereafter, the support was dried at 100 °C and calcined in the air at 600 °C to obtain catalyst particles.

## Experimental Example 1. Confirmation of XRD pattern of Catalyst

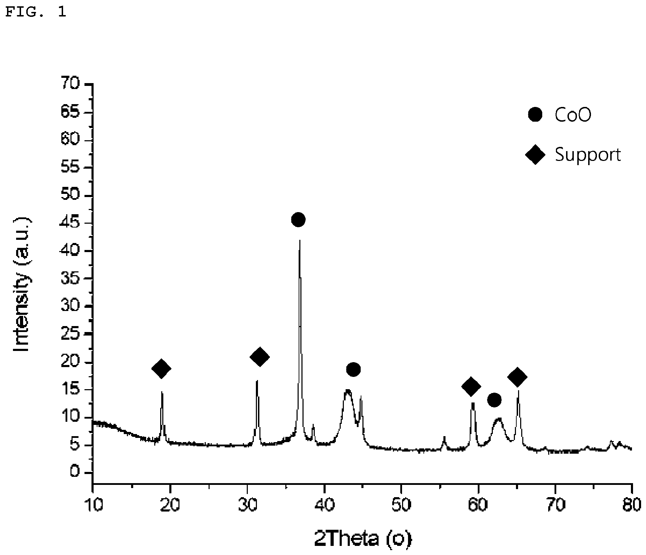

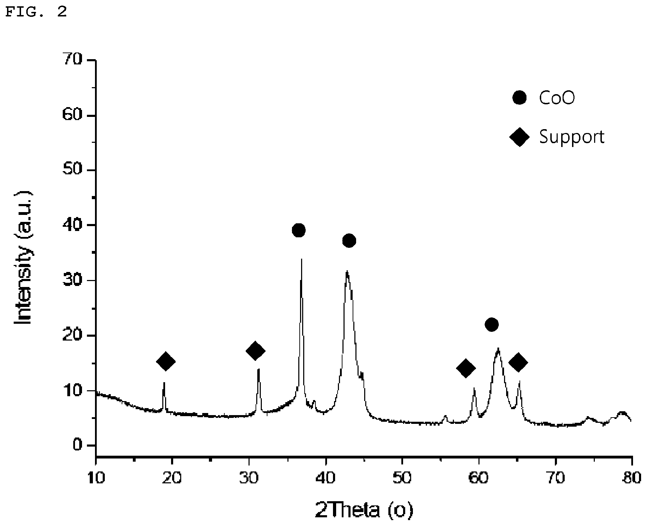

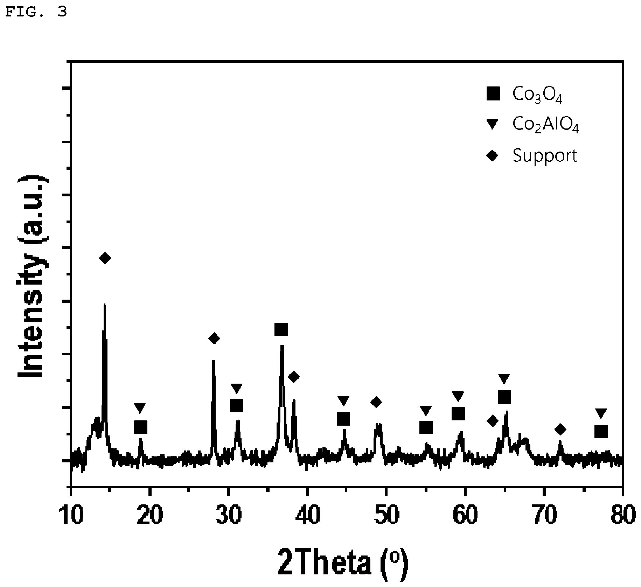

The XRD patterns of the catalysts prepared in Examples and Comparative Example were measured, and the measured results are shown in FIGS. 1 to 3. As shown in FIGS. 1 to 3, a catalyst according to Examples of the present invention show, depending on the presence of CoO, one peak at $2\Theta=35°$ to $38°$ and one peak at $2\Theta=41°$ to $44°$. On the other hand, in the case of the catalyst prepared in Comparative Example the peak did not appear clearly due to the low content of CoO.

In addition, the ratios (at%) of CoO among the CoO and $Co_3O_4$ in the active layer of the catalyst prepared in Examples and Comparative Example were calculated by the following method.

1) CoO ratio (at%) : the [O]/[Co] (at%) ratio of the catalyst coating layer was calculated through ICP. Co in the coating layer is present as CoO or $Co_3O_4$, and therefore if the proportion of CoO is x, the proportion of $Co_3O_4$ is 1-x. Since [O]/[Co]={x+4(1-x)}/{x+3(1-x)}, x may be calculated through the [O]/[Co] ratio value. Also, ICP-OES analysis was performed using Optima 8300DV (Perkin-elmer Co.) under following conditions.

Measuring Conditions: RF Power 1300W, Torch Height 15mm, Plasma gas flow 15L/min, Sample Gas flow 0.8L/min, Aux. Gas flow 0.2L/min

As a result of the calculation, it was confirmed that the [O]/[Co] value in Example 1 was 1.004 and the proportion of CoO was 99.5%, the [O]/[Co] value of Example 2 was 1.115 and the proportion of CoO was 85.0%, and the [O]/[Co] value in Comparative Example was 1.270 and the proportion of CoO was 41.1%.

## Experimental Example 2. Confirmation of Catalyst Properties

The properties of the catalysts prepared in Examples and Comparative Example were confirmed through the following method.

1) Catalyst layer thickness: Platinum (Pt) or carbon was sputtered on catalyst layer particles to a thickness of 100 nm, and thereafter, a sectional specimen was prepared using focused ion beam (FIB) or $Ar^+$ ion milling. The prepared specimen was analyzed using a SEM or TEM to measure the thickness of the catalyst layer.
2) Catalyst content: The catalyst content was confirmed through ICP component analysis, and ICP-OES analysis was performed by dissolving 0.1 g of catalyst particles in 1 ml of hydrochloric acid and the resultant solution was diluted 10 times.

Measuring equipment: ICP-OES Agilent 5110
Measuring condition: RF Power 1300W, Torch Height 15mm, Plasma gas flow 15L/min, Sample Gas flow 0.8L/min, Aux. Gas flow 0.2L/min, Pump Speed 1.5ml/min

3) Coverage: The coverage was calculated using the previously measured catalyst content, catalyst layer thickness, specific surface area and catalyst density of the support, and was calculated through the following Equation. Also, the theoretical true density value of the catalyst adopted in the present invention is 6 g/cm$^3$.

$$\text{Coverage=catalyst content/(catalyst layer thickness*support specific surface area*theoretical true density of catalyst)}$$

4) Yield: The yield was calculated as a multiple obtained by measuring the weight of the produced carbon nanotubes per the input amount of the catalyst particles (including both catalyst and support).
5) Produced amount of carbon nanotubes per input amount of catalyst: This value was calculated as a multiple obtained by measuring the weight of the produced carbon nanotubes per the catalyst content (excluding support) of the input catalyst particles.

The measured values for each properties are summarized in Table 1 below.

[Table 1]

|  | Example 1 | Example 2 | Comparative Example |
|---|---|---|---|
| Catalyst thickness | 0.9 nm | 2.7 nm | 15 nm |
| Catalyst content | 1.4% | 4.2% | 7% |
| Coverage | 16.5% | 16.5% | 5% |
| yield | 8 times | 6.5 times | 10 times |
| Carbon nanotube production compared to catalyst input | 533 times | 155 times | 143 times |

As may be seen in Table 1, in the catalyst according to Examples of the present invention, catalyst components are uniformly and thinly distributed on the surface of the support even with a low catalyst content, thereby making it possible to synthesize significantly larger amounts of carbon nanotubes than conventional supported catalysts even using the same amount of catalyst input.

**Experimental example 3. Confirmation of Properties of Carbon Nanotubes Produced from Catalyst**

Carbon nanotubes were synthesized using the catalysts prepared in Examples and Comparative Examples. Specifically, 10 mg of the catalyst was put into a tube furnace, and 500 sccm of nitrogen gas, 200 sccm of hydrogen gas, and 50 sccm of ethylene gas were injected at 670 °C for 90 minutes to synthesize carbon nanotubes.

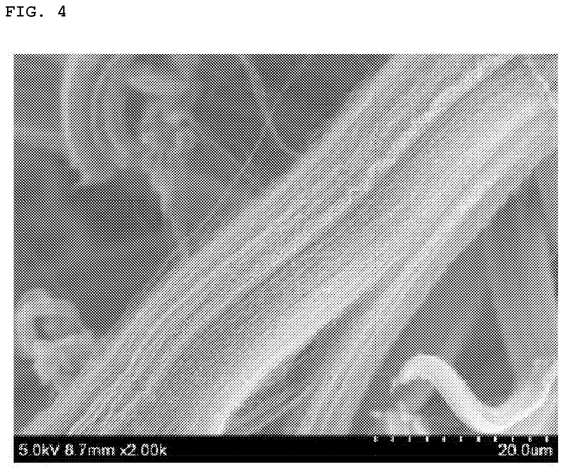

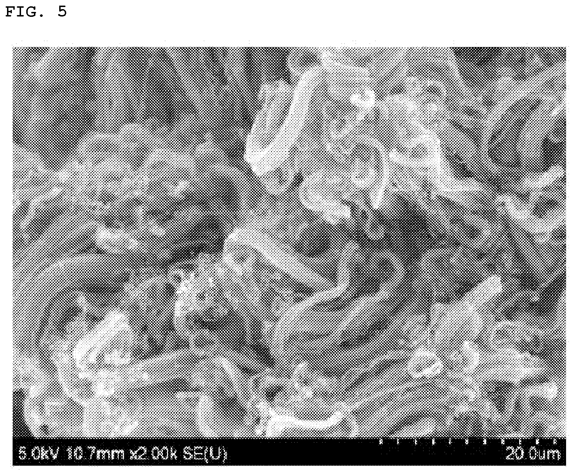

FIG. 4 shows a SEM image of carbon nanotubes produced using the catalyst of Example 1, FIG. 5 shows a SEM image of carbon nanotubes produced using the catalyst of Comparative Example, and SEM images were observed using JSM-7610F (JEOL).
As may be seen in FIGS. 4 and 5, the carbon nanotubes produced using the catalyst prepared by the methods according to Examples of the present invention has a thick single bundle, and excellent alignment of the carbon nanotubes in the bundle, whereas the carbon nanotubes produced using the catalyst according to Comparative Example has a thin single bundle, and poor alignment of the carbon nanotubes. This means that the use of the catalyst, which is prepared using the catalyst preparation method according to the present invention, enables the synthesis of excellent carbon nanotubes in terms of electrical conductivity and dispersibility.

**Claims**

1.  A catalyst for producing carbon nanotubes the catalyst comprising:

    a support; and
    an active layer formed on a surface of the support,
    wherein the active layer contains CoO and $Co_3O_4$, and shows, through XRD pattern measurement, one peak at $2\theta=35°$ to $38°$, and one peak at $2\theta=41°$ to $44°$, and
    a proportion of CoO among the CoO and $Co_3O_4$ is 55 at% or more.

2.  The catalyst of claim 1, wherein the support is a metal oxide support having a hydroxyl group on a surface thereof.

3.  The catalyst of claim 1, wherein the support has a specific surface area of 1 m$^2$/g to 300 m$^2$/g.

4.  The catalyst of claim 1, wherein the support has a number-average particle size of 0.5 um to 100 $\mu$m.

5.  The catalyst of claim 1, wherein the support is at least one selected from the group consisting of aluminum oxide, hydrotalcite, and boehmite.

6.  The catalyst of claim 1, wherein the catalyst has an active layer content of 1 wt% to 10 wt%.

7.  The catalyst of claim 1, wherein the catalyst has an active layer thickness of 0.5 nm to 5 nm.

8.  A method for preparing a catalyst for producing carbon nanotubes, the method comprising

    a step of loading a support into a reactor (S1), and
    a step of forming a catalyst layer on a surface of the support using atomic layer deposition (S2),
    wherein, the step (S2) is performed by sequentially repeating the following steps 5 to 300 times:

    a step of injecting a catalyst precursor gas into the reactor (S2-1);
    a step of primary purging the inside of the reactor with an inert gas (S2-2);
    a step of injecting a reaction gas into the reactor (S2-3); and
    a step of secondarily purging the inside of the reactor with an inert gas (S2-4).

9.  The method of claim 8, further comprising a step (S0) of pre-treating the support before or after the step S1.

10.  The method of claim 8, wherein the reaction gas contains nitrogen or oxygen.

11.  The method of claim 8, wherein the step S2 is performed under a pressure condition of 0.1 Torr to 10 Torr.

12.  The method of claim 8, wherein the step S1 further comprises heating the inside of the reactor to 100 °C to 400 °C.

13.  A method for producing carbon nanotubes, the method comprising:

    a step of filling the inside of a reactor (S1) with the catalyst of claim 1;
    a step of injecting a carbon source gas into the reactor (S2); and
    a step of heating the reactor (S3).

FIG. 1

FIG. 2

FIG. 3

FIG. 4

FIG. 5

5.0kV 10.7mm x2.00k SE(U)　　　20.0um

## INTERNATIONAL SEARCH REPORT

| | International application No. |
|---|---|
| | **PCT/KR2023/000588** |

### A. CLASSIFICATION OF SUBJECT MATTER

**B01J 37/02**(2006.01)i; **B01J 35/10**(2006.01)i; **B01J 35/02**(2006.01)i; **B01J 23/75**(2006.01)i; **B01J 37/08**(2006.01)i; **C01B 32/162**(2017.01)i; **C23C 16/455**(2006.01)i

According to International Patent Classification (IPC) or to both national classification and IPC

### B. FIELDS SEARCHED

Minimum documentation searched (classification system followed by classification symbols)

B01J 37/02(2006.01); B01J 23/75(2006.01); B01J 37/08(2006.01); C01B 31/02(2006.01); C01B 32/162(2017.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 탄소나노튜브(carbon nano tube), 촉매(catalyst), 산화코발트(cobalt oxide), 지지체(support), 원자막 증착법(atomic layer deposition)

### C. DOCUMENTS CONSIDERED TO BE RELEVANT

| Category* | Citation of document, with indication, where appropriate, of the relevant passages | Relevant to claim No. |
|---|---|---|
| Y | KR 10-2021-0036725 A (LG CHEM, LTD.) 05 April 2021 (2021-04-05)<br>See claims 1-7 and 13; and paragraphs [0052] and [0108]. | 1-13 |
| Y | BELLES, L. et al. Flame Spray Pyrolysis Co3O4/CoO as Highly-Efficient Nanocatalyst for Oxygen Reduction Reaction. Nanomaterials. 2021, vol. 11, no. 4, document no. 925, pp. 1-18.<br>See abstract; page 6, 3.1 Characterization of the FSP-Made Cobalt-Oxide Nanocatalysts; and table 1. | 1-7,13 |
| Y | DONDERES, M. E. et al. Remote Plasma Atomic Layer Deposition of Co3O4 Thin Films. Journal of The Electrochemical Society. 2011, vol. 158, no. 4, pp. G92-G96.<br>See page G92. | 8-12 |
| A | JP 2002-338221 A (MITSUBISHI GAS CHEM. CO., INC.) 27 November 2002 (2002-11-27)<br>See entire document. | 1-13 |
| A | JP 2015-150515 A (TOYO INK SC HOLDINGS CO., LTD.) 24 August 2015 (2015-08-24)<br>See entire document. | 1-13 |

☐ Further documents are listed in the continuation of Box C.   ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **19 April 2023** | **19 April 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2023/000588**

| Patent document cited in search report | | | Publication date (day/month/year) | Patent family member(s) | | | Publication date (day/month/year) |
|---|---|---|---|---|---|---|---|
| KR | 10-2021-0036725 | A | 05 April 2021 | None | | | |
| JP | 2002-338221 | A | 27 November 2002 | JP | 2005-338221 | A5 | 19 May 2005 |
| | | | | JP | 3912583 | B2 | 09 May 2007 |
| | | | | US | 2003-0147801 | A1 | 07 August 2003 |
| | | | | US | 6967013 | B2 | 22 November 2005 |
| JP | 2015-150515 | A | 24 August 2015 | JP | 2016-150515 | A5 | 10 November 2016 |
| | | | | JP | 6237311 | B2 | 29 November 2017 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220005135
- KR 1020220005137
- KR 1020200141772 A
- KR 1020180101222 A